# EUROPEAN PATENT SPECIFICATION

(11) **EP 1 946 376 B1**
(45) Date of publication and mention of the grant of the patent: **07.03.2018**
(21) Application number: 06799250.3
(22) Date of filing: 16.10.2006
(51) Int. Cl.: G01B 11/25, G01B 11/06, H01L 27/148, H04N 13/02

(54) **APPARATUS FOR AND METHOD OF MEASURING IMAGE**
VORRICHTUNG UND VERFAHREN ZUR BILDMESSUNG
APPAREIL ET PROCEDE DE MESURE D'UNE IMAGE

(30) Priority: 19.10.2005 KR 20050098851
(43) Date of publication of application: 23.07.2008
(73) Proprietor: Intekplus Co., Ltd, Daejeon 305-500 (KR)
(72) Inventor: LEE, Sang-yoon, Daejeon 305-728 (KR); CHOI, Yi-bae, Daejeon 305-325 (KR); KANG, Min-gu, Daejeon 305-755 (KR); LIM, Ssang-gun, Daejeon 302-741 (KR)
(74) Representative: Grünecker Patent- und Rechtsanwälte PartG mbB
(86) International application number: PCT/KR2006/004172
(87) International publication number: WO 2007/046601

(56) References cited:
- JP-A- 06 066 534
- KR-A- 20040 026 927
- KR-A- 20050 031 328
- KR-A- 20050 045 511
- US-A- 5 784 098
- US-A1- 2003 043 387
- US-A1- 2003 179 385
- US-B1- 6 438 272

## Description

### BACKGROUND OF THE INVENTION

### Field of the Invention

The present invention relates to an optical image measuring apparatus and a method of optically measuring an image, and particularly to, an image measuring apparatus for acquiring an image taken by an optical system at high speed and a method thereof.

### Description of the Related Art

Electronic and mechanical components are vigorously being required to be made smaller and more accurate, and in order to check processing and manufacturing statuses of the small electronic and mechanical components, their sizes, shapes, and surface illuminance must be measured very precisely.

KR 1020050031328 A discloses a method and an apparatus for three-dimensional inspection using a stereo vision and a Moire are provided to detect a defect of a lead of a package having a bending state and a phase value of 180 degrees and more by overcoming limitation of ambiguity.

KR 20040026927 A discloses an apparatus and a method for capturing a photographing image at a high speed are provided to improve productivity by shortening a test process for an object using an optical profile measurement system.

US 2003/0043387 A1 discloses a method and apparatus for measuring a three-dimensional shape using a projection Moire device, in which a measurement of the three-dimensional shape is made using a projection grid without a reference grid.

For example, sizes, shapes, laser marked statuses, and surface illuminance of an electronic component, that is, a semiconductor wafer and a micro-pattern of an integrated circuit fabricated on the semiconductor wafer cannot be measured by a conventional contact-type measuring apparatus. Moreover, in a case of using a contact-type surface illuminance measuring apparatus using a contact probe, a tip of the contact probe generates fine scratches on a surface of an object to be measured and it is hard to acquire information about an area thereof.

In order to solve the above problems, a 2-dimensional measuring apparatus and a method thereof and a 3-dimensional measuring apparatus and a method thereof, that use an optical microscope, have been developed to measure the shape of the object to be measured by projecting light emitted from a light source to the object to be measured according to a reference pattern and comparing the reference pattern with light modified due to the shape of the object.

As the 3-dimensional shape measuring method, a method using Moire pattern is widely used recently. The shape measuring method using Moire pattern forms an interference pattern whose two or more periodic patterns having predetermined configurations are overlapped with each other on a surface of an object to be measured (hereinafter, referred to an "object"), and acquires information about a height of the object by measuring and analyzing an interference pattern.

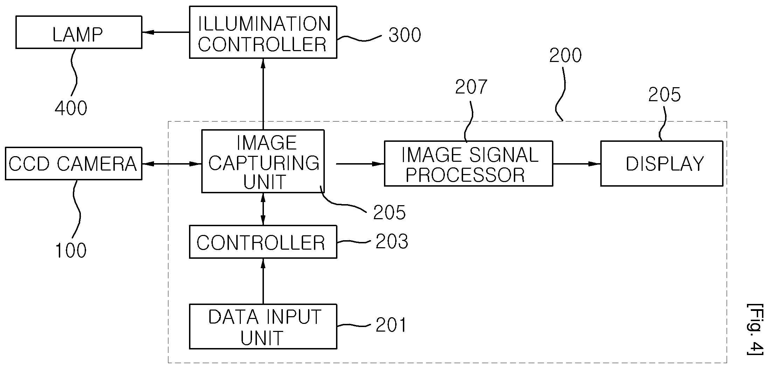

FIG. 4 is a block diagram illustrating a process of acquiring an image in a conventional optical shape measuring apparatus.

The conventional shape measuring apparatus includes a CCD camera 100 to take an image of an object and to output the image when a trigger signal is inputted from an image capturing device 205 that is described later, a plurality of lamps 400 installed at different places to adjust surface illuminance of parts of the object to be tested, and an illuminating controller 300 to control the plural lamps 400. The illuminating controller 300 controls the lamps 400 according to the trigger signal generated by the image capturing device 205 that is installed in a computer 200.

Meanwhile, the image capturing device 205 installed in the computer 200 performs a function of capturing the image outputted from the CCD camera 100 and transmitting the image to an image signal processor 207. The image capturing device 205 generates and outputs a trigger signal to synchronize the illuminating controller 300 and the CCD camera 100 and captures the image outputted from the CCD camera 100.

In this way, a plurality of heights in a scanning area of the object P is acquired to measure unevenness of the object P.

That the lamps are turned on by the trigger signal and an image of the object must be taken at this time is because the captured image must be acquired while turning on the lamps 400 for acquiring an image of a surface of the object to be measured.

For reference, image signal processor 207 receives the captured image and processes the captured image into an image signal to be displayed on a display 209, and a controller 203 transmits the processed image signal to the image capturing device 205 when an image measuring start command is inputted from a data input device 201.

In the conventional optical shape measuring apparatus having the above-described configuration, the CCD camera takes and outputs images whenever the trigger signals are generated from the image capturing device, and the image capturing device disposed at the rear side thereof captures the images outputted from the CCD camera and transmits the same and after that generates the trigger signals again. Therefore, it takes a long time for acquiring image frames.

For example, if a time required to capture a single image frame is 0.03 seconds and a time required to transmit the captured image is 0.03 seconds, a time required to take and transmit a total of ten image frames is (N + 2) × 0.03 seconds, namely, 12 × 0.06 = 0.72 seconds.

For this reason, since the conventional optical shape measuring apparatus has a difficulty of rapidly acquiring the captured images, time for testing the object to be measured cannot be shortened.

### SUMMARY OF THE INVENTION

Therefore, the present invention has been made in view of the above and/or other problems, and it is an object of the present invention to provide an image measuring apparatus for measuring a 3-dimensional image of an object to be measured using an image captured by an optical system in which an image of the object is rapidly captured and the captured image is acquired at a high rate and a method thereof.

It is a further object of the present invention to provide an image measuring apparatus for removing noise generated during the measurement and a high frequency component generated from an edge, and a method thereof.

In accordance with the present invention, the above and other objects can be accomplished by the provision of an apparatus for measuring a three-dimensional image of an object to be measured using an image captured by an optical system, the apparatus including a CCD camera for capturing the object and outputting the captured image, a lamp for generating light to illuminate a capturing area of the object, an illumination controller for controlling the lamp to be turned on, a projection grating formed with gratings, a projection grating driving unit for adjusting a distance between the projection grating and the object, an image capturing device for acquiring the image captured by the CCD camera, a driving signal generator unit for outputting a driving signal to the illumination controller, the projection grating driving unit, and the image capturing device simultaneously according to an enable signal generated from the CCD camera, and an image signal processor for estimating a three-dimensional image of the object from data transmitted from the image capturing device; wherein the driving signal generator unit comprises a memory storing reference data necessary for the control of generating the driving signal, a digital-to-analog converter, a low pass filter for removing high frequency components from a signal outputted from the digital-to-analog converter and a signal acquired by the image capturing device, and a driving signal generator for generating the driving signal.

In accordance with the present invention, the above and other objects can be accomplished by the provision of a method of measuring a three-dimensional image of an object to be measured using an image captured by an optical system, the method providing a driving signal generator unit comprising a memory storing reference data necessary for the control of generating a driving signal, a digital-to-analog converter, a low pass filter for removing high frequency components from a signal outputted from the digital-to-analog converter and a signal acquired by an image capturing device, and a driving signal generator; detecting an enable signal from a CCD camera; outputting, by the driving signal unit, the driving signal simultaneously according to the enable signal to an illumination controller for turning on a lamp to project light on the object, a projection grating driving unit for adjusting a distance between the object and a projection grating, and the image capturing device to transmit an image captured by the CCD camera to an image signal processor; storing a phase-shifted interference pattern transmitted to the signal processor by repeating the detecting and the outputting; determining whether the capturing of the object is finished or not; and in case it is determined that the capturing of the object is finished acquiring the three-dimensional image using a plurality of stored interference pattern information.

### BRIEF DESCRIPTION OF THE DRAWINGS

These and/or other aspects and advantages of the present invention will become apparent and more readily appreciated from the following description of the embodiments, taken in conjunction with the accompanying drawings, in which:
FIG. 1 is a schematic view illustrating a configuration of an image measuring apparatus according to the present invention;
FIG. 2 is a block diagram illustrating the image measuring apparatus according to the present invention;
FIG. 3 is a flowchart illustrating an image measuring method according to the present invention; and
FIG. 4 is a block diagram illustrating a process of acquiring an image in a conventional optical shape measuring apparatus.

### DESCRIPTION OF THE PREFERRED EMBODIMENTS

The embodiments of the present invention will be described in detail with reference to accompanying drawings such that those skilled in the art may fully understand and achieve the concept of the present invention.

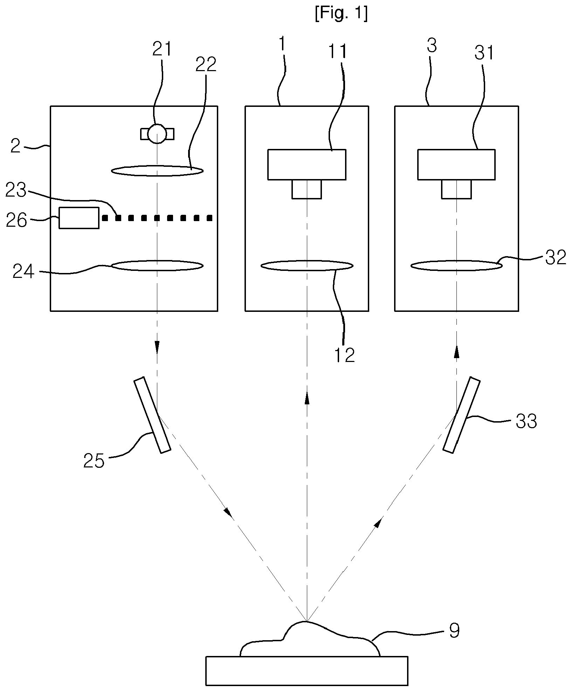

FIG. 1 is a view illustrating a configuration of an optical system of an image measuring apparatus according to the present invention. The optical system includes an optical projector 24 for condensing a light beam generated from a lamp 21 using a condenser lens 22 and for projecting the light beam on an object P via a reflecting mirror 25 through a projection grating 23 and a projection lens 24, and a first light optical receiver 1 for acquiring a modified grating patterned image from the object P through an image forming lens 12 and a CCD camera 11.

At a side of the projection grating 23, a projection grating driving unit 26 is further provided to adjust a distance between the projection grating 23 and the object P.

Moreover, the optical system may include a second light receiver 3 for acquiring a stereo image of the object P through an image forming lens 32 and a stereo vision camera 31.

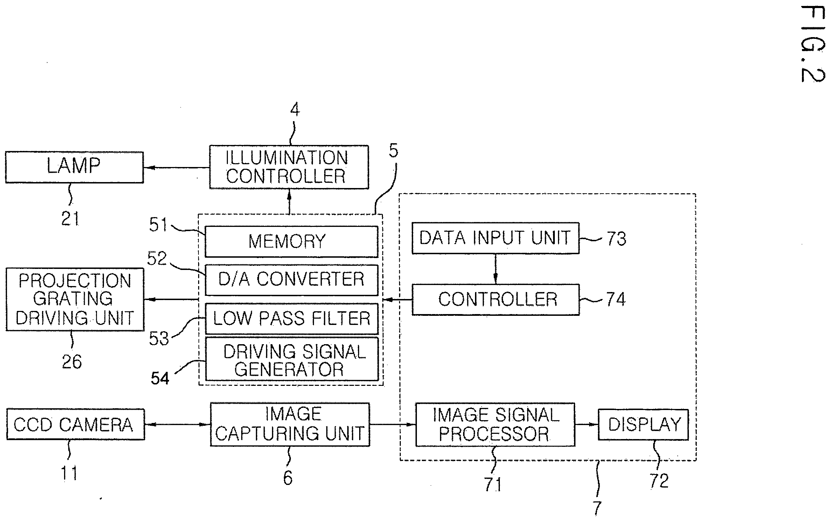

FIG. 2 is a block diagram illustrating the image measuring apparatus according to the present invention. The high rate image measuring apparatus according to the present invention includes a CCD camera 11 for capturing the image of the object P and outputting the captured image, a lamp 21 for generating light to illuminate a capturing area of the object P, an illumination controller 4 for controlling the turning on of the lamp 21, a projection grating 23 in which gratings are formed, a projection grating driving unit 26 for adjusting a distance between the projection grating 23 and the object P, an image capturing device 6 for acquiring a captured image through the CCD camera 11, a driving signal generator unit 5 for simultaneously outputting a driving signal to the illumination controller 4, the projection grating driving unit, and the image capturing device 6 according to an enable signal from the CCD camera 1, and an image signal processor 71 for estimating a 3-dimensional shape of the object from data transmitted from the image capturing device 6.

The projection grating driving unit 26 is provided to adjust the distance between the projection grating 23 and the object P such that a phase of grating pattern projected on the object P is changed.

The driving signal generator unit 5 includes a memory 51 for storing reference data necessary for the control of generating the driving signal, a digital-to-analog (D/A) converter 52, a low pass filter 53 for removing high frequency components from a signal outputted from the digital-to-analog converter 52 and a signal acquired by the image capturing device 6, and a driving signal generator 54 for generating a driving signal.

The D/A converter 52 is configured to reduce operating time of a computer, and the low pass filter 53 is configured to remove the noise generated during the measurement of height information of the object P and the high frequency components generated at the edges thereof.

The image signal processor 71 receives the captured image and converts the same into an image signal to be displayed on the display 72 to output the image signal, and a controller 74 transmits an image measurement start command to the CCD camera when the image measurement start command is inputted from a measurer to the controller 74 via a data input unit 73.

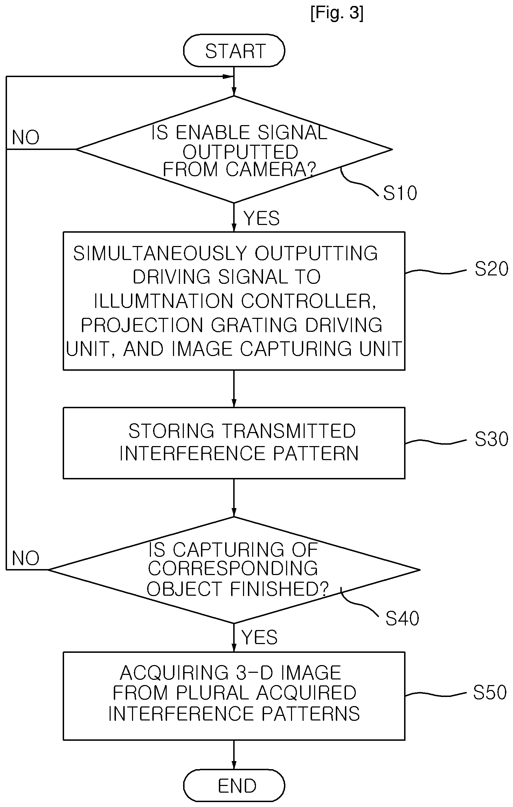

FIG. 3 is a flowchart illustrating an image measuring method according to the present invention. In the method of measuring height information of an object using an image captured by an optical system, when an enable signal is detected from the CCD camera (S10), the driving signal generator unit 5 outputs an image acquiring driving signal to the illumination controller 4, the projection grating driving unit 26, and the image capturing device 6 simultaneously such that the driving signal to control illumination required to capture a corresponding image frame and the captured image to adjust a position of the grating are acquired and transmitted to the image signal processor 71 (S20).

Next, when the acquired interference pattern information transmitted to the image signal processor 71 is stored and the enable signal is detected from the CCD camera in order to acquire the phase-shifted interference pattern, the steps (S10 and S20) of simultaneously outputting the image acquiring driving signal to acquire the illumination control required to capture a corresponding image frame and the captured image to adjust a position of the grating are repeated (S30).

After that, when the capturing of the object is finished (S40), the 3-dimensional image is acquired using a plurality of the stored interference pattern information (S50).

As such, according to the present invention, the illumination and the grating are controlled and the image is acquired and transmitted whenever the enable signal of the CCD camera is detected so that a time required to acquire the image is reduced and the 3-dimensional image of the object can be measured at high speed.

For example, if a time for capturing a single image frame is 0.03 seconds and a time for transmitting the captured image is 0.03 seconds, a time for capturing and transmitting a total of ten image frames is (10 + 1.5) × 0.03 = 0.345 seconds.

In other words, since a time, that is, (N + 1.5) × (a time for capturing a single image frame) is required to capture N images, a high speed measuring is enabled in comparison to the conventional method when N is greater than 2. In more detail, according to the conventional method, when N is 1 (one), it takes (1 × 2 × 0.03) = 0.06 seconds. however, according to the present invention, since it takes (1 + 1.5) × 0.03 = 0.075 seconds, the high speed measuring is enabled when N is greater than 2 (two).

Moreover, according to the present invention, a signal meaning that the acquiring of an image is finished is generated before the captured image is transmitted to the image signal processor when a final image enters the camera. Therefore, since the image is transmitted simultaneously with the acquiring of the final image, a single frame time for transmitting the final image can be saved so that the high speed measuring of requiring only time (N + 0.5) × (a time for capturing a single image frame) is enabled when acquiring N images according to used measuring modules.

As described above, according to the present invention, since the driving signal is simultaneously outputted to the lamp and the image capturing device to capture a corresponding frame whenever the enable signal of the CCD camera is detected, the captured images can be acquired at high speed.

Moreover, the D/A converter is provided in the driving signal generator unit to reduce the operating time of the computer and the low pass filter is provided to remove noise generated when measuring the image of the object and the high frequency components generated at the edges thereof so that the precision of the acquired image can be improved.

Although the preferred embodiments of the present invention have been disclosed for illustrative purposes, those skilled in the art will appreciate that various modifications, additions and substitutions are possible, without departing from the scope of the invention as defined in the accompanying claims.

## Claims

1. An apparatus for measuring a three-dimensional image of an object (P) to be measured using an image captured by an optical system, the apparatus comprising:
a CCD camera (11) for capturing the object (P) and outputting the captured image;
a lamp (21) for generating light to illuminate a capturing area of the object (P);
an illumination controller (4) for controlling the lamp (21) to be turned on;
a projection grating (23) formed with gratings;
a projection grating driving unit (26) for adjusting a distance between the projection grating (23) and the object (P);
an image capturing device (6) for acquiring the image captured by the CCD camera (11);
a driving signal generator unit (5) for outputting a driving signal to the illumination controller (4), the projection grating driving unit (26), and the image capturing device simultaneously according to an enable signal generated from the CCD camera (11);
an image signal processor (71) for estimating a three-dimensional image of the object (P) from data transmitted from the image capturing device;
wherein the driving signal generator unit (5) comprises:
a memory (51) storing reference data necessary for the control of generating the driving signal;
a digital-to-analog converter (52);
a low pass filter (53) for removing high frequency components from a signal outputted from the digital-to-analog converter (52) and a signal acquired by the image capturing device (6); and
a driving signal generator (54) for generating the driving signal.

2. A method of measuring a three-dimensional image of an object (P) to be measured using an image captured by an optical system, the method comprising:
providing a driving signal generator unit (5) comprising a memory (51) storing reference data necessary for the control of generating a driving signal, a digital-to-analog converter (52), a low pass filter (53) for removing high frequency components from a signal outputted from the digital-to-analog converter (52) and a signal acquired by an image capturing device (6), and a driving signal generator (54);
detecting (S10) an enable signal from a CCD camera (11);
outputting (S20), by the driving signal unit (5), the driving signal simultaneously according to the enable signal to an illumination controller (4) for turning on a lamp (21) to project light on the object (P), a projection grating driving unit (26) for adjusting a distance between the object (P) and a projection grating (23), and the image capturing device (6) to transmit an image captured by the CCD camera (11) to an image signal processor (71);
storing (S30) a phase-shifted interference pattern transmitted to the signal processor (71) by repeating the detecting and the outputting;
determining (S40) whether the capturing of the object (P) is finished or not; and
in case it is determined that the capturing of the object (P) is finished acquiring (S50) the three-dimensional image using a plurality of stored interference pattern information.

## Patentansprüche

1. Vorrichtung zum Messen eines dreidimensionalen Bildes eines zu messenden Objekts (P) unter Verwendung eines von einem optischen System aufgenommenen Bildes, die Vorrichtung umfassend:
eine CCD-Kamera (11) zum Aufnehmen des Objekts (P) und Ausgeben des aufgenommenen Bildes;
eine Lampe (21) zum Erzeugen von Licht zum Beleuchten einer Aufnahmefläche des Objekts (P);
einen Beleuchtungsregler (4) zum Ansteuern der Lampe (21), um eingeschaltet zu werden;
ein Projektionsgitter (23), das mit Gitterlinien ausgebildet ist;
eine Projektionsgitter-Antriebseinheit (26) zum Einstellen einer Entfernung zwischen dem Projektionsgitter (23) und dem Objekt (P);
ein Bildaufnahmegerät (6) zum Erlangen des von der CCD-Kamera (11) aufgenommenen Bildes;
eine Antriebssignalerzeugungeinheit (5) zum simultanen Ausgeben eines Antriebssignals an den Beleuchtungsregler (4), an die Projektionsgitter-Antriebseinheit (26), und an das Bildaufnahmegerät entsprechend einem von der CCD-Kamera (11) erzeugten Freigabesignals;
einen Bildsignalprozessor (71) zum Abschätzen eines dreidimensionalen Bildes des Objekts (P) aus von dem Bildaufnahmegerät übermittelten Daten;
wobei die Antriebssignalerzeugungeinheit (5) umfasst:
eine Speichereinheit (51) zum Speichern von Referenzdaten, welche notwendig sind für das Steuern des Erzeugens des Antriebssignals;
einen Digital-Analog-Wandler (52);
einen Tiefpassfilter (53) zum Entfernen von Hochfrequenzkomponenten aus einem von dem Digital-Analog-Wandler (52) ausgegebenen Signal, und einem von dem Bildaufnahmegerät (6) erlangten Signal; und
einen Antriebssignalerzeuger (54) zum Erzeugen des Antriebssignals.

2. Verfahren zum Messen eines dreidimensionalen Bildes eines zu messenden Objekts (P) unter Verwendung eines von einem optischen System aufgenommenen Bildes, das Verfahren umfassend:
Bereitstellen einer Antriebssignalerzeugungeinheit (5) umfassend eine Speichereinheit (51) zum Speichern von Referenzdaten, welche notwendig sind für das Steuern des Erzeugens eines Antriebssignals, einen Digital-Analog-Wandler (52), einen Tiefpassfilter (53) zum Entfernen von Hochfrequenzkomponenten aus einem von dem Digital-Analog-Wandler (52) ausgegebenen Signal, und einem von dem Bildaufnahmegerät erlangten Signal, und einen Antriebssignalerzeuger (54);
Detektieren (S10) eines Freigabesignals von einer CCD-Kamera (11);
simultanes Ausgeben (S20), durch die Antriebssignaleinheit (5), des Antriebssignals entsprechend dem Freigabesignal an einen Beleuchtungsregler (4) zum Einschalten einer Lampe (21), um Licht auf das Objekt (P) zu projizieren, an eine Projektionsgitter-Antriebseinheit (26) zum Einstellen einer Entfernung zwischen dem Objekt (P) und einem Projektionsgitter (23), und an das Bildaufnahmegerät (6) zum Übermitteln eines von der CCD-Kamera (11) aufgenommenen Bildes an einen Bildsignalprozessor (71);
Speichern (S30) eines an den Signalprozessor übermittelten, phasenverschobenen Interferenzmusters, durch Wiederholen des Detektierens und Ausgebens;
Bestimmen (S40), ob das Aufnehmen des Objekts (P) abgeschlossen ist oder nicht; und
falls bestimmt wird, dass das Aufnehmen des Objekts (P) abgeschlossen ist, Erlangen (S50) des dreidimensionalen Bildes unter Verwendung einer Vielzahl von gespeicherten Interferenzmuster-Informationen.

## Revendications

1. Appareil de mesure d'une image tridimensionnelle d'un objet (P) à mesurer à l'aide d'une image capturée par un système optique, l'appareil comprenant:
une caméra CCD (11) pour capturer l'objet (P) et délivrer en sortie l'image capturée;
une lampe (21) pour générer de la lumière pour éclairer une zone de capture de l'objet (P);
un contrôleur d'éclairage (4) permettant de commander l'allumage de la lampe (21);
un réseau de projection (23) formé de grilles;
une unité d'entraînement de réseau de projection (26) pour ajuster une distance entre le réseau de projection (23) et l'objet (P);
un dispositif de capture d'image (6) pour acquérir l'image capturée par la caméra CCD (11);
une unité génératrice de signe d'entraînement (5) pour délivrer en sortie un signal d'entraînement au contrôleur d'éclairage (4), à l'unité d'entraînement de réseau de projection (26), et le dispositif de capture d'image simultanément selon un signal de validation généré par la caméra CCD (11);
un processeur de signal d'image (71) destiné à estimer une image en trois dimensions de l'objet (P) à partir des données transmises par le dispositif de capture d'image;
dans lequel l'unité de générateur de signal d'entraînement (5) comprend:
une mémoire (51) stockant des données de référence nécessaires pour la commande de génération du signal d'entraînement;
un convertisseur numérique-analogique (52);
un filtre passe-bas (53) permettant de retirer des composantes haute fréquence d'un signal émis par le convertisseur numérique-analogique (52) et un signal acquis par le dispositif de capture d'image (6); et
un générateur de signal d'attaque (54) pour générer le signal d'entraînement.

2. Procédé de mesure d'une image tridimensionnelle d'un objet (P) à mesurer à l'aide d'une image capturée par un système optique, le procédé consistant à:
fournir une unité de génération de signal d'entraînement (5) comprenant une mémoire (51) stockant des données de référence nécessaires à la commande de génération d'un signal d'entraînement,
un convertisseur numérique-analogique (52), un filtre passe-bas (53) pour supprimer des composantes haute fréquence à partir d'un signal émis par le convertisseur numérique-analogique (52) et un signal acquis par un dispositif de capture d'image (6) et un générateur de signal d'entraînement (54);
détecter (S10) un signal de validation provenant d'une caméra CCD (11);
délivrer en sortie (S20), par l'unité de signal d'entraînement (5), le signal d'entraînement en même temps selon le signal de validation vers un contrôleur d'éclairage (4) pour allumer une lampe (21) afin de projeter de la lumière sur l'objet (P), une unité d'entraînement de réseau de projection (26) pour ajuster une distance entre l'objet (P) et un réseau de projection (23), et le un dispositif de capture d'image (6) pour transmettre une image capturée par la caméra CCD (11) à un processeur de signal d'image (71);
mémoriser (S30) un motif d'interférence déphasé transmis au processeur de signal (71) en répétant la détection et la sortie;
déterminer (S40) si la capture de l'objet (P) est terminée ou non; et
au cas où l'on détermine que la capture de l'objet (P) a terminé l'acquisition (S50) de l'image en trois dimensions en utilisant une pluralité d'informations de motif d'interférence enregistrées.
